# EUROPÄISCHE PATENTSCHRIFT

(11) **EP 1 715 532 B1**
(45) Veröffentlichungstag und Bekanntmachung des Hinweises auf die Patenterteilung: **07.03.2007**
(21) Anmeldenummer: 05008704.8
(22) Anmeldetag: 21.04.2005
(51) Int. Cl.: H01L 51/30

(54) **Verfahren zur Herstellung polymerer elektrisch leitender Schichten**
Process for the formation of polymeric electrically conductive films
Procédé pour la formation de films polymériques électriquement conducteurs

(43) Veröffentlichungstag der Anmeldung: 25.10.2006
(73) Patentinhaber: INPRO Innovationsgesellschaft für fortgeschrittene Produktionssysteme in der Fahrzeugindustrie mbH, 10587 Berlin (DE)
(72) Erfinder: Stechmann, Dipl.-Ing. Lea, 10999 Berlin (DE); Minkow, Dipl.-Ing. Michael, 13593 Berlin (DE)
(74) Vertreter: Hoffmann, Klaus-Dieter

(56) Entgegenhaltungen:
- WO-A-20/04035857
- US-A- 4 410 640
- AUDENAERT M ET AL: "Electrical conductivity of I2-doped polyacetylene" Physical Review B (Condensed Matter) USA, Bd. 24, Nr. 12, 15. Dezember 1981 (1981-12-15), Seiten 7380-7382, XP002344072 ISSN: 0163-1829
- MARKOWITSCH W ET AL: "Free carriers in heavily doped polyacetylene" POLYCONJUGATED MATERIALS: CHEMISTRY, PHYSICS AND TECHNOLOGY. SYMPOSIUM G. E-MRS FALL CONFERENCE 4-7 NOV. 1991 STRASBOURG, FRANCE, Bd. 51, Nr. 1-3, 1. September 1992 (1992-09-01), Seiten 25-29, XP002344073 Synthetic Metals Switzerland ISSN: 0379-6779
- GOYAL K O ET AL: "Mass transport characteristics in a pulsed plasma enhanced chemical vapor deposition reactor for thin polymer film deposition" IEEE Transactions on Plasma Science IEEE USA, Bd. 29, Nr. 1, 1. Februar 2001 (2001-02-01), Seiten 42-50, XP002344074 ISSN: 0093-3813
- HONG MENG ET AL.: "Facile Solid-State Synthesis of Highly Conducting Poly(ethylenedioxythiophene)" ANGEWANDTE CHEMIE, INTERNATIONAL EDITION, Bd. 42, Nr. 6, 2003, Seiten 658-661, XP002344157

## Beschreibung

Die Erfindung betrifft ein Verfahren zur Herstellung polymerer, temporär elektrisch leitender Schichten, insbesondere von Polyacetylen-Schichten unter Verwendung von Acetylengas und Iod.

Kunststoffe sind grundsätzlich Isolatoren, die aufgrund ihrer chemischen Struktur keinen elektrischen Strom leiten können und, im Gegensatz zu Metallen, prinzipiell über keine freie Elektronen verfügen.

Damit auch in Kunststoffen eine freie Elektronenleitung stattfinden kann, muß das Polymer aus einer Kohlenstoffkette oder einer Ringstrukur (Thiophen, Pyrrol, Anilin) mit konjugierten Doppelbindungen, d.h. mit sich abwechselnden Einfach- und Doppelbindungen zwischen den Kohlenstoffatomen bestehen. Das Acetylen (C₂ H₂) besteht aus zwei Kohlenstoffatomen, die durch eine Dreifachbindungen verbunden sind. Diese Dreifachbindung besteht aus einer σ und zwei π-Bindungen. Die π-Elektronen sind delokalisiert über das Molekül gleichmäßig verteilt. Durch die Polymerisation zu Polyacetylen verteilen sich die freien π-Elektronen über das gesamte Kettenmolekül. Damit diese Kettenmoleküle den elektrischen Strom leiten, müssen sie dotiert werden. Chemisch bedeutet dies, daß entweder Elektronen von den Ketten von außen mittels Elektronenakzeptoren entfernt oder mittels Elektronendonatoren hinzugefügt werden, und zwar analog wie beim metallischen Halbleiter. Die Elektronenakzeptoren neigen aufgrund ihrer Elektronenkonfiguration dazu, dem Kettenmolekül Elektronen zu entziehen, um ihre äußere Valenzschale zu vervollständigen. Die Elektronendonatoren haben hingegen nur ein freies Elektron auf ihrer äußeren Valenzschale und geben dieses freie Elektron leicht an das System ab.

Diese freien Elektronen sind nun - wie bei Metallen - nicht mehr an die Atomrümpfe gebunden, sondern können sich in dem Kettenmolekül des Polymers frei bewegen und elektrische Ladungen transportieren.

Die Herstellung von elektrisch leitenden Kunststoffen wird seit längerer Zeit erforscht. So erhielten im Jahre 2000 Hideki Shirakawa, Alan Heeger und Alan Mac Diarmid für die Erkenntnis den Nobelpreis für Chemie, wie Polyacetylenkettenmoleküle elektrischen Strom leiten und behandelt werden müssen, damit sie sich wie Metalle verhalten. Sie entwickelten ein Verfahren, bei dem flüssiges Polyacetylen katalytisch naßchemisch aus Acetylengas hergestellt und anschließend mit Ioddampf dotiert wird. Die elektrische Leitfähigkeit des erhaltenen Polyacethylens, das anschließend auf die Oberfläche eines Substrats aufgetragen werden muß, ist ähnlich der Leitfähigkeit von Kupfer oder Silber, d.h. 600.000 S/cm.

Bekannt ist aus der US-A-4 410 640 (Kobayashi et al) (1983-10-18) ein Dotierverfahren zur Erhöhung der Leitfähigkeit von Polyacetylen durch dessen Einbringen in einen Reaktionskessel, in dem nach dessen Evakuierung eine Iodatmosphäre erzeugt wird.

Bekannt ist weiterhin aus der WO 2004/035857 A (2004-04-29) die Abscheidung von Polyacetylenschichten mittels Plasma-CVD-Verfahren auf Kunststoffsubstraten.

Die vorliegende Erfindung steht im Zusammenhang mit der Nutzung der Plasmapolymerisation zur Erzeugung von lackhafienden, elektrisch leitfähigen Kunststoffoberflächen. Zielrichtung ist insbesondere die Entwicklung eines alternativen Verfahrens zur Erzeugung elektrisch leitfähiger Kunststoffoberflächen mittels Plasmabeschichtung für die elektrostatische in-line und on-line Lackierung (ESTA), sowie die Substitution der drei Verfahrensschritte Aktivierung, Lackieren mit konventionell eingesetztem Primer und anschließendem Einbrennen eines Leitprimers.

Für die elektrostatische Lackierung, die einen hohen Wirkungsgrad der Lackauftragung gewährleistet, muß die Oberfläche von Kunststoffteilen leitfähig eingestellt werden. Herkömmlich wird hierzu naßchemisch ein Leitprimer auf die Oberfläche appliziert, wobei die Leitfähigkeit des entsprechenden Kunststoffteils durch die Rußfüllung des Leitprimers realisiert wird. Aufgrund der Rußfüllung sind konventionelle Leitprimer schwarz bzw. dunkelblau. Dieser Umstand ist jedoch bei gewünschten hellen Basecoat-Farbtönen (weiß, gelb, rot) aufgrund der Farbtonunterschiede / Läufergrenze problematisch. Zur Lösung des Problems können zur Zeit sehr teure helle Leitprimer bzw. Naß-in-Naß-Lackierungen von dunklen Leitprimern und zusätzlich helleren Primern eingesetzt werden.

Der Erfindung liegt daher die Aufgabe zugrunde, ein Verfahren der eingangs erwähnten Art zur Verfügung zu stellen, mit dem in kostengünstiger Weise ein unmittelbares Beschichten der Oberfläche eines Kunststoffsubstrats mit einer elektrisch leitenden Schicht, insbesondere mit einer elektrisch leitenden Polyacetylenschicht möglich ist.

Diese Aufgabe wird erfindungsgemäß durch die folgenden, aneinanderanschließenden Verfahrensschritte gelöst:
- Positionieren eines Kunststoffsubstrats innerhalb einer Plasmakammer unterhalb einer Gaszuführung für das Acetylengas,
- Evakuieren der Plasmakammer auf Niederdruckatmosphäre,
- Zuleiten von Sauerstoffgas in die Plasmakammer und Bilden eines Plasmas in letzterer mittels Energieeintrag durch verhältnismäßig niedrig eingestellte Mikrowellenstrahlung,
- Einleiten einer Niederdruckplasmapolymerisation unter Zuleiten des Acetylengases durch die Gaszuführung in die Plasmakammer und unter fortgesetztem Energieintrag durch die Mikrowellenstrahlung, wobei das Acetylengas bei weiterer Verringerung der Mikrowellenleistung dahingehend fragmentiert wird, daß teilweise die Doppelbindungen des Acetylens erhalten bleiben und sich durch die Niederdruckplasmapolymerisation eine dreidimensional verzweigte Acetylen-Plasmapolymerschicht mit einem noch weiter verbreiteten delokalisierten π-Elektrodensystem ausbildet und auf der Oberfläche des Kunststoffsubstrats niederschlägt,
- Entnehmen des mit der Acetylen-Plasmapolymerschicht versehenen Kunststoffsubstrats aus der Plasmakammer,
- Positionieren des beschichteten Kunststoffsubstrats innerhalb eines geschlossenen Glasbehälters, und
- Erzeugen einer gesättigten Ioddampfatmosphäre in dem geschlossenen Glasbehälter, wobei die Acetylen-Plasmapolymerschicht des Kunststoffsubstrats mit Iod dotiert und dabei elektrisch leitend gemacht wird.

Vorzugsweise erfolgen die Evakuierung der Plasmakammer bis auf einen Kammerdruck von 20 Pa, die Zuleitung des Sauerstoffgases in einer Menge von 100 ml/ min über eine Zeitdauer t von 60 s bei einer Mikrowellenleistung von 1000 W und die Zuleitung des Acetylengases in einer Menge von 200 ml/min über eine Zeitdauer t von 180 s bei einer Mikrowellenleistung von 300 W.

Vorteilhafterweise werden der Glasbehälter mit Abmaßen von 30 cm x 27 cm x 6 cm und das Kunststoffsubstrat als DIN A-4 förmige Platte gewählt und 20g Iodkristalle in dem Glasbehälter gleichmäßig verteilt, die bei Raumtemperaturbedingungen sublimieren.

Zur gezielten Steigerung der erzeugten elektrischen Leitfähigkeit der Acetylen-Plasmapoylmerschicht des Kunststoffsubstrats kann dieses in der gesättigten Ioddampfatmosphäre innerhalb des geschlossenen Glasbehälters über eine vorbestimmte verlängerte Zeitdauer gelagert werden.

Das erfindungsgemäße Verfahren erweist sich als besonders wirtschaftlich, da im Verfahrensablauf selbst die Beschichtung des Kunststoffsubstrats mit einer polymeren, temporär elektrisch leitenden Schicht möglich ist. Unter Raumtemperaturbedingungen sublimieren die lodkristalle in dem Glasbehälter, in dem das mit der Acetylen-Plasmapolymerschicht versehene Kunststoffsubstrat positioniert ist. Mit einer Erhöhung der Temperatur kann dieser Prozeß deutlich beschleunigt werden. Sobald die loddampfatmosphäre in dem Glasbehälter gesättigt ist, kristallisieren die Iodkristalle an der Oberfläche des Kunststoffsubstrats, wobei die Acetylen-Plasmapolymerschicht mit Iod dotiert und elektrisch leitend gemacht wird. Einzelne, metallisch aussehende Kristallisationsinseln weisen eine besonders gute elektrische Leitfähigkeit auf.

Die Oberflächenleitfähigkeit der mit dem erfindungsgemäßen Verfahren hergestellten elektrisch leitenden Acetylen/Iod-Schichten liegt in der Größenordnung von 10⁻⁷ S. Diese verhältnismäßig geringe Oberflächenleitfähigkeit im Vergleich zu der von naßchemisch hergestellten Polymeren erklärt sich dadurch, daß Plasmapolymere im Gegensatz zu geordneten Polyacetylenmolekülketten in einem vollkommen ungeordneten Zustand vorliegen und sich daher sehr in Struktur und Zusammensetzung von dem konventionell hergestellten Polymer unterscheiden. Beachtlich ist jedoch, daß weder das im Plama hergestellte, noch das naßchemisch hergestellte Polyacetylen/Iod aufgrund seiner jeweils strukturbedingten Instabilität gegen Sauerstoff und Luftfeuchtigkeit dauerhaft elektrisch leitend ist.

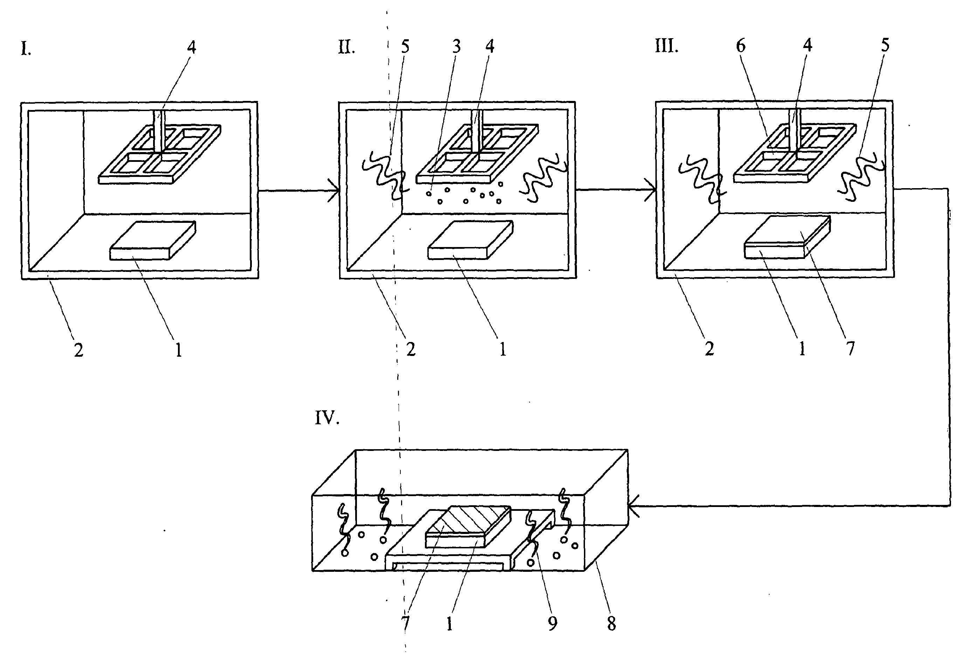

Eine bevorzugte Ausführungsform des erfindungsgemäßen Verfahrens wird nun anhand der einzigen Figur der Zeichnung erläutert.

Kunststoffsubstrat 1 innerhalb einer Plasmakammer 2 unterhalb einer Gaszuführung 4 angeordnet und die Plasmakammer 2 nach Verschließen auf einen Kammerdruck von 20 Pa evakuiert. In einem zweiten Verfahrensschritt II erfolgt die Zuleitung von Sauerstoffgas 3 über die Gaszuführung 4 in die Plasmakammer 2 unter gleichzeitigem Energieeintrag durch Mikrowellenstrahlung 5, was zu einer Aktivierung der Oberfläche des Kunststoffsubstrats 1 fführt. Geeigneterweise wird das Sauerstoffgas 3 in einer Menge von 100 ml/min über einen Zeitraum t von 60s bei einer Mikrowellenleistung von 1000 W in die Plasmakammer 2 zugeführt. In einem dritten Verfahrensschritt III wird Acetylengas 6 über die Gaszuführung 4 in die Plasmakammer 2 eingeleitet und unter Verringerung der Mikrowellenleistung fragmentiert derart, daß teilweise die Doppelbildungen des Acetylens erhalten bleiben und sich während der Niederdruckplasmapolymersiation eine dreidimensional verzweigte Acetylen-Plasmapolymerschicht 7 mit einem noch weiter verbreiteten delokalisierten π-Elektrodensysten ausbildet und auf der Oberfläche des Kunststoffsubstrats 1 niederschlägt. Geeigneterweise wird das Acetylengas 6 in einer Menge von 200 ml/min über eine Zeitdauer t von 180 s bein einem Energieeintrag mittels Mikrowellen 5 von 200 W in die Plasmakammer 2 zugefuhrt.

Nach Bildung der Acetylen-Plasmapolymerschicht 7 auf der Oberfläche des Kunststoffsubstrats 1 wird dieses der Plasmakammer 2 entnommen und innerhalb eines geschlossenen Glasbehälters 8 angeordnet. In einem vierten Verfahrensschritt IV wird dann in dem geschlossenen Glasbehälter 8 eine gesättigte Ioddampfatmosphäre 9 erzeugt und die Acetylen-Plasmapolymerschicht 7 auf der Oberfläche des Kunststoffsubstrats 1 mit Iod dotiert und dadurch elektrisch leitend gemacht.

### Liste der Bezugszeichen:

- 1: Kunststoffsubstrat
- 2: Plasmakammer
- 3: Sauerstoffgas
- 4: Gaszuführung
- 5: Mikrowellenstrahlung
- 6: Acetylengas
- 7: Acetylen Plasmapolymerschicht
- 8: Glasbehälter
- 9: Ioddampfatmosphäre

## Patentansprüche

1. Verfahren zur Herstellung polymerer, temporär elektrisch leitender Schichten, insbesondere von Polyacetylen-Schichten unter Verwendung von Acetylengas und Iod, **gekennzeichnet durch** folgende Verfahrensschritte:
- Positionieren eines Kunststoffsubstrats (1) innerhalb einer Plasmakammer (2) unterhalb einer Gaszuführung (4) für das Acetylengas,
- Evakuieren der Plasmakammer (2) auf Niederdruckatmosphäre,
- Zuleiten von Sauerstoffgas (3) in die Plasmakammer (2) und Bilden eines Plasmas in letzterer mittels Energieeintrag **durch** verhältnismäßig niedrig eingestellte Mikrowellenstrahlung (5)
- Einleiten einer Niederdruckplasmapolymerisation unter Zuleiten des Acetylengases (6) **durch** die Gaszuführung in die Plasmakammer (2) und unter fortgesetztem Energieeintrag **durch** die Mikrowellenstrahlung (5) wobei das Acetylengas (6) bei weiterer Verringerung der Mikrowellenleistung dahingehend fragmentiert wird, daß teilweise die Doppelbindungen des Acetylens erhalten bleiben und sich **durch** die Niederdruckplasmapolymerisation eine dreidimensional verzweigte Acetylen-Plasmapolymerschicht (7) mit einem noch weiter verbreiteten delokalisierten π-Elektrodensystem ausbildet und auf der Oberfläche des Kunststoffsubstrats (1) niederschlägt,
- Entnehmen des mit der Acetylen-Plasmapolymerschicht (7) versehenen Kunststoffsubstrats (1) aus der Plasmakammer (2),
- Positionieren des beschichteten Kunststoffsubstrats (1), innerhalb eines geschlossenen Glasbehälters (8), und
- Erzeugen einer gesättigten Ioddampfatmosphäre (9) in dem geschlossenen Glasbehälter (8), wobei die Acetylen-Plasmapolymerschicht (7) auf der Oberfläche des Kunststoffsubstrats mit Iod (9) dotiert und dabei elektrisch leitend gemacht wird.

2. Verfahren nach Anspruch 1, **dadurch gekennzeichnet, daß** die Evakuierung der Plasmakammer (2) bis auf einen Kammerdruck von 20 Pa, die Zuleitung des Sauerstoffgases in einer Menge von 100 ml/ min über eine Zeitdauer t von 60 s bei einer Mikrowellenleistung von 1000 W und die Zuleitung des Acetylengases (6) in einer Menge von 200 ml/min über eine Zeitdauer t von 180 s bei einer Mikrowellenleistung von 300 W erfolgen.

3. Verfahren nach Anspruch 1 und 2, **dadurch gekennzeichnet, daß** der Glasbehälter (8) mit Abmaßen von 30 cm x 27 cm x 6 cm und das Kunststoffsubstrat (1) als DIN A-4 förmige Platte gewählt und 20g Iodkristalle in dem Glasbehälter (8) gleichmäßig verteilt werden, die bei Raumtemperaturbedingungen sublimieren.

4. Verfahren nach einem der vorgehenden Ansprüche 1 bis 3, **dadurch gekennzeichnet, daß** das mit der Acetylen-Plasmapoylmerschicht (7) versehene Kunststoffsubstrat (1) in der gesättigten Ioddampfatmosphäre (9) innerhalb des geschlossenen Glasbehälter (8) zur gezielten Steigerung der erzeugten elektrischen Leitfähigkeit seiner Acetylen-Plasmapolymerschicht (7) über eine vorbestimmte verlängerte Zeitdauer gelagert wird.

## Claims

1. A process for producing polymeric, temporarily electrically conductive layers, in particular polyacetylene layers using acetylene gas and iodine,
**characterized by** the following process steps:
- positioning a plastic substrate (1) inside a plasma chamber (2) beneath a gas feed (4) for the acetylene gas,
- evacuating the plasma chamber (2) to a low-pressure atmosphere,
- supplying oxygen gas (3) into the plasma chamber (2) and forming a plasma in the latter by means of energy input due to a relatively low setting of the microwave radiation (5),
- initiating low-pressure plasma polymerization with an input of acetylene gas (6) through the gas feed into the plasma chamber (2) and with continued energy input through the microwave radiation (5), whereby the acetylene gas (6) is fragmented with a further reduction in the microwave power so that the double bonds of acetylene are partially preserved, and a three-dimensionally branched acetylene plasma polymer layer (7) is formed due to the low-pressure plasma polymerization, with an even more broadened delocalized π-electron system and is deposited on the surface of the plastic substrate (1),
- removing the plastic substrate (1) furnished with the acetylene plasma polymer layer (7) from the plasma chamber (2),
- positioning the coated plastic substrate (1) inside a closed glass container (8) and
- generating a saturated iodine vapor atmosphere (9) in the closed glass container (8), whereby the acetylene plasma polymer layer (7) is doped onto the surface of the plastic substrate with iodine (9) and thereby rendered electrically conductive.

2. The method according to Claim 1,
**characterized in that**
the plasma chamber (2) is evacuated to a chamber pressure of 20 Pa, the oxygen gas is introduced in an amount of 100 mL/min for a period t of 60 seconds at a microwave power of 1000 W and the feed of acetylene gas (6) is continued in an amount of 200 mL/min over a period of time t of 180 seconds at a microwave power of 300 W.

3. The method according to Claims 1 and 2,
**characterized in that**
the glass container (8) is selected with dimensions of 30 cm x 27 cm x 6 cm and the plastic substrate (1) is selected as a DIN A-4 sheet and 20 grams of iodine crystals are uniformly distributed in the glass container (8), subliming under room temperature conditions.

4. The method according to any one of the preceding Claims 1 through 3,
**characterized in that**
the plastic substrate (1) provided with the acetylene plasma polymer layer (7) is stored for a predetermined extended period of time in the saturated iodine vapor atmosphere (9) inside the closed gas container (8) for a controlled increase in the electric conductivity thereby generated in its acetylene plasma polymer layer (7).

## Revendications

1. Procédé pour la formation de films qui, temporairement, sont électriquement conducteurs, notamment de films de polyacétylène, en utilisant du gaz d'acétylène et de l'iode, **caractérisé par** la mise en oeuvre des étapes de procédé suivantes :
- positionnement d'un substrat de matière plastique (1) au sein d'une chambre à plasma (2), en-dessous d'une arrivée de gaz (4) pour le gaz d'acétylène,
- évacuation de la chambre à plasma (2) pour y créer une atmosphère à basse pression,
- introduction de gaz d'oxygène (3) dans la chambre à plasma (2) et formation d'un plasma dans ladite chambre par un apport d'énergie sous forme de radiation micro-ondes (5) réglée à une intensité relativement faible,
- initiation d'une polymérisation par plasma à basse pression en introduisant du gaz d'acétylène (6) à travers l'arrivée de gaz dans la chambre à plasma (2) et en continuant d'apporter de l'énergie sous forme de radiation micro-ondes (5), le gaz d'acétylène (6) étant fragmenté, sous l'effet d'une puissance des micro-ondes encore réduite, de manière à conserver en partie les doubles liaisons de l'acétylène et à former, par polymérisation par plasma à basse pression, un film polymérique à base de plasma d'acétylène (7), ce film, qui présentant un système d'électrons n délocalisés encore plus étendu, étant déposé sur la surface du substrat de matière plastique (1),
- enlèvement du substrat de matière plastique (1) pourvu d'un film polymérique à base de plasma d'acétylène (7) de la chambre à plasma (2),
- positionnement du substrat de matière plastique (1) recouvert du film au sein d'un récipient en verre (8) fermé, et
- mise en place d'une atmosphère saturée en vapeur d'iode (9) dans le récipient en verre (8) fermé, le film polymérique à base de plasma d'acétylène (7) sur la surface du substrat de matière plastique étant ainsi dopé d'iode (9) pour le rendre électriquement conducteur.

2. Procédé selon la revendication 1, **caractérisé en ce que** l'évacuation de la chambre à plasma (2) est effectuée jusqu'à atteindre une pression de chambre égale à 20 Pa, et que l'introduction du gaz d'oxygène est effectuée dans une quantité de 100 ml/min. et ce durant une période t de 60 s à une puissance des micro-ondes égale à 1000 W, et que l'introduction du gaz d'acétylène (6) est effectuée dans une quantité de 200 ml/min. et ce durant une période t de 180 s à une puissance des micro-ondes égale à 300 W.

3. Procédé selon les revendications 1 et 2, **caractérisé en ce que** le récipient en verre (8) est choisi tel qu'il présente des dimensions de 30 cm x 27 cm x 6 cm et le substrat de matière plastique (1) tel qu'il correspond au format A4, et que 20 g de cristaux d'iode sont répartis uniformément dans le récipient en verre (8), les cristaux sublimant dans des conditions de température ambiante.

4. Procédé selon les revendications 1 a 3, **caractérisé en ce que** le substrat de matière plastique (1) pourvu d'un film polymérique à base de plasma d'acétylène (7) est entreposé dans l'atmosphère saturée en vapeur d'iode (9) dans le récipient en verre (8) fermé pendant une période prolongée dont la durée à été définie au préalable, dans l'objectif d'augmenter la conductivité électrique provoquée dans son film polymérique à base de plasma d'acétylène (7).
